# EUROPEAN PATENT APPLICATION

(11) **EP 4 391 763 A1**
(43) Date of publication of application: **26.06.2024**
(21) Application number: 22216117.6
(22) Date of filing: 22.12.2022
(51) Int. Cl.: H10K 10/46, H10K 85/20

(54) **A TUNNELING ENABLED FEEDBACK FET**

(71) Applicant: Imec VZW, 3001 Leuven (BE)
(72) Inventor: AFZALIAN, Aryan, 1450 Chastre (BE)
(74) Representative: Winger

(57) **Abstract**

A feedback field effect transistor (100) comprising a source region (110), a channel region (120), a drain region (130), and a gate (140). The channel region (120) is between the source (110) and the drain region (130). The source region (110), the channel region (120), and the drain region (130) are comprising a semiconductor material with a bandgap which is smaller than 0.9 eV. The source region (110) and/or the drain region (130) have/has a dopant concentration which is smaller than 5×10¹⁹ cm⁻³ and the gate is positioned along the channel and isolated from the channel.

## Description

### Field of the invention

The invention relates to the field of field effect transistors. More specifically it relates to a feedback field effect transistor.

### Background of the invention

With an increasing number of semiconductor devices per chip a decreasing device size is needed. Typical device dimensions today range from a few nm to tens of nm, making the pursuit of dimension scaling increasingly difficult. As a consequence, semiconductor devices are evolving from planar MOS structures to 3D multigated transistors such as FinFETs or nanowires (NW) and novel material like 2D materials or carbon nanotubes (CNTs) are sought after. Among other issues, power consumption and heat dissipation have become a key concern in modern CMOS technologies due to the ever-increasing number of transistors per unit area, and new energy efficient switches are sought as replacement to the MOSFET concept.

In a MOSFET, the lower limit for the subthreshold slope (SS), or the inverse slope of the drain current - gate voltage characteristic *I*_{D}(*V*_{G}) of a transistor, is In*(10)×kT*/*q.* In other words, at least 60 mV of gate voltage variation is required to change the current by a decade at room temperature. This sets a practical limit to reductions of supply voltage and power consumption of a circuit. Achieving steeper-subthreshold-slope transistors has become a key concern for further CMOS downscaling, and different concepts to overcome this limitation have been proposed. This includes devices using a multi-physic effect triggered by *V*_{G}, such as electromechanical motion in the Suspended-Gate (SG)-MOSFET or replacing the standard gate insulator with a ferroelectric insulator of the right thickness in the ferroelectric FET. Other concepts attempt to use impact ionization, or energy filtering with tunnel barriers and resonant tunneling in the Resonant Tunneling FET (RTFET), by means of a superlattice to create minibands in the Superlattice FET, or by using band-to-band tunneling (BTBT) through gate modulation of a reverse-biased PN junction in a tunnel FET (TFET), or using a so called cold-source metal in the cold-source FET. Despite the progress in the field, a satisfying steep-slope device is still missing and V_{DD} has not been scaled below 0.7 V.

It has also been shown that a positive feedback mechanism can lead to a steep SS in the Feedback field-effect transistors (FBFETs). FBFETs are devices based on a positive feedback loop in which the electrons and holes in the channel region act on the energy states of the potential barrier and wall. FBFETs were first proposed in 2008. The design of the FBFET is similar, with a P-I-N diode under forward bias. It exhibits positive feedback with double potential barriers. Surrounding the channel region close to the source and drain, gate-sidewall spacers fabricated to trap charges play the role of potential barriers on the FBFET. Each barrier that blocks the flow of electrons and holes makes it possible to utilize P-I-N diodes as FBFETs. Typically, these devices use more complex structures than a regular MOSFET, such as PNPN structures or PIN structure with at least 2 gates and rely on 2 reservoirs (typically where electrons and holes are exchanged) that are spatially separated (close to the source and drain, gate-sidewall spacers). This renders the fabrication process more complex and prevent to scale down the transistors.

There is therefore a need for alternative designs for FBFETs which permit to scale down the FBFETs.

### Summary of the invention

It is an object of embodiments of the present invention to provide a good design of a FBFET and a method for making such a FBFET.

The above objective is accomplished by a method and device according to the present invention.

In a first aspect embodiments of the present invention relate to a FBFET. The FBFET comprises a source region, a channel region, a drain region, and a gate.

The source region, the channel region, and the drain region are comprising a semiconductor material with a bandgap which is smaller than 0.9 eV and the source region or the drain region or both have a dopant concentration which is smaller than 5×10¹⁹ cm⁻³.

The gate is positioned along the channel and isolated from the channel.

In embodiments of the present invention the semiconductor material is a carbon nanotube. In embodiments of the present invention the semiconductor material is selected from the list of germanium, III-V material, graphene, black phosphorus.

In embodiments of the present invention the drain region has a dopant concentration which is smaller than 5×10¹⁹ cm⁻³ and the source region has a dopant concentration of more than 5×10¹⁹ cm⁻³.

In embodiments of the present invention a dopant of the source is a n-type dopant. In embodiments of the present invention a dopant of the source is a p-type dopant.

In embodiments of the present invention the device comprises a source electrode in contact with the source region, and a drain electrode in contact with the drain region.

In embodiments of the present invention a length of the channel is between 3 and 100 nm.

In embodiments of the present invention a length of the source or drain is between 3 and 40 nm.

Embodiments of the present invention may also relate to a logic device comprising a plurality of FBFETs according to embodiments of the present invention, wherein the FBFETs are arranged in a logic configuration.

Embodiments of the present invention may also relate to a memory device comprising a FBFET according to embodiments of the present invention. The memory device is configured for determining whether the feedback field effect transistor is in a high or low conductive state based on a conductivity of the feedback field effect transistor.

In a second aspect embodiments of the present invention relate to a method for operating a FBFET. The method comprises applying a drain-source voltage between the drain region and the source region. The drain-source voltage should at least be 0.2 V.

The method, furthermore, comprises increasing the gate voltage from 0 V to a first predefined gate voltage until a drain polarity reverts, and increasing the gate voltage from the first predefined voltage to a second predefined voltage to switch on the feedback field effect transistor.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG. 1 shows a 3D schematic drawing of an exemplary FBFET, in accordance with embodiments of the present invention.
FIG. 2 shows the drain current in function of the gate voltage of a FBFET in accordance with embodiments of the present invention.
FIG. 3 shows the subthreshold slope in function of the drain current for a FBFET in accordance with embodiments of the present invention.
FIG. 4 shows the conduction band profile along the channel direction (x) for various gate voltages V_{G} in a first phase of the forward sweep of a FBFET in accordance with embodiments of the present invention.
FIG. 5 shows the conduction band profile along the channel direction (x) for various gate voltages V_{G} in a second phase of the forward sweep of a FBFET in accordance with embodiments of the present invention.
FIG. 6 shows the conduction band profile along the channel direction (x) for various gate voltages V_{G} in a third phase of the forward sweep of a FBFET in accordance with embodiments of the present invention.
FIG. 7 shows the channel bands along the channel direction in a fourth phase of the forward sweep of a FBFET in accordance with embodiments of the present invention.
FIG. 8 shows the carrier concentration along the channel direction in a first phase and in a third phase of a FBFET in accordance with embodiments of the present invention.
FIG. 9 shows the carrier concentration along the channel direction for various gate voltages of a FBFET in accordance with embodiments of the present invention.
FIG. 10 shows the band profile and the current spectrum J(E) along the channel direction for various gate voltages of a FBFET in accordance with embodiments of the present invention.

Any reference signs in the claims shall not be construed as limiting the scope. In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

This invention proposes a new type of band-to-band-tunneling (BTBT) enabled FBFET, that can work with a single gate and does not require a PIN structure. It does require a low bandgap material such as CNT, Ge or III-V (e.g. InAs, InSb), etc. Other low bandgap 2D materials such as graphene, black Phosphorus, etc. can also be used.

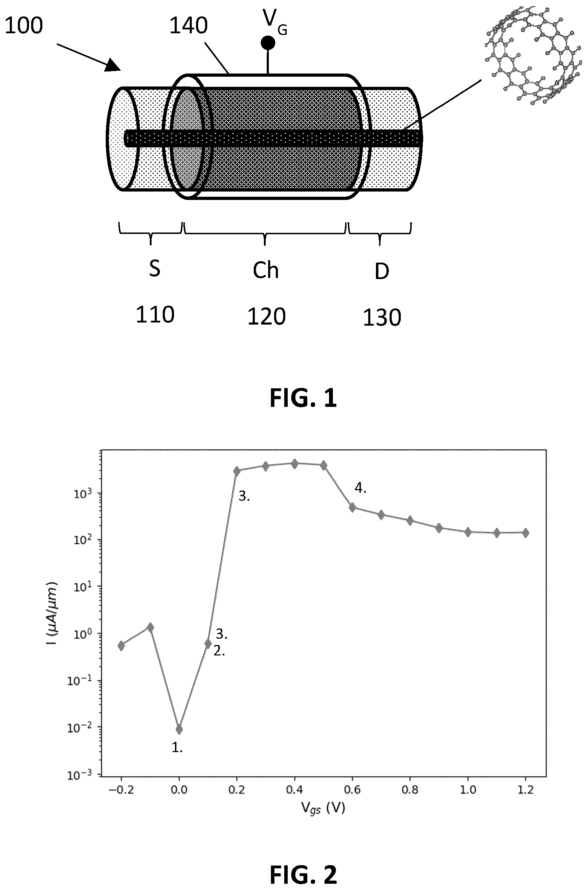

In a first aspect embodiments of the present invention relate to a feedback field effect transistor (FBFET) 100. A 3D schematic drawing of an exemplary embodiment of such FBFET is shown in FIG. 1. In embodiments of the present invention the FBFET comprises a source region 110, a channel region 120, a drain region 130, and a gate 140.

The channel region 120 is between the source region 110 and the drain region 130. The source region 110, the channel region 120, and the drain region 130 are comprising a semiconductor material with a bandgap which is smaller than 0.9 eV. The bandgap may for example be between 0.7 and 0.5 eV.

The source region 110 and/or the drain region 130 have/has a dopant concentration which is smaller than 5×10¹⁹ cm⁻³ and the gate is positioned along the channel and isolated from the channel. The gate may be a single gate (SG), double gate (DG), triple gate, gate all around (GAA). In the example in FIG. 1 the gate is a cylindrical gate (GAA) with tₒₓ=3 nm and εₒₓ=23.4.

It is an advantage of embodiments of the present invention that the exchange of n and p can be triggered by band to band tunneling from the conduction band to the valence band within a single (non-spatially separated) channel region. This is possible because the semiconductor material of the field effect transistor has a bandgap which is smaller than 0.9 eV and because the source region and/or the drain region have/has a dopant concentration which is smaller than 5×10¹⁹ cm⁻³. In embodiments of the present invention any dopant suitable for effectively doping the material or even electrostatic doping may be used.

In embodiments of the present invention the dopant concentration of the drain may for example be smaller than 2×10¹⁹ cm⁻³ or even smaller than or equal to 1×10¹⁹ cm⁻³.

In embodiments of the present invention the dopant concentration of the source may be more than 1×10¹⁹ cm⁻³, or even equal to or more than 2×10¹⁹ cm⁻³ or even equal to or more than 5×10¹⁹ cm⁻³. In embodiments of the present invention the drain region 130 has a dopant concentration which is smaller than 5×10¹⁹ cm⁻³ and the source region 110 has a dopant concentration of more than 5×10¹⁹ cm⁻³.

It is an advantage of embodiments of the present invention that abrupt switching can be obtained by changing the charge carrier type from electron (n) to hole (p) abruptly within a region or reservoir (typically the channel barrier) when turning a n-type device from off to on (and vice versa for a p-type device). This ensures an abrupt collapse of the energy barrier of the region and a very steep transition from off to on state.

It is, therefore, an advantage of embodiments of the present invention that field effect transistors with a steep subthreshold slope can be obtained.

In embodiments of the present invention the source, the drain and the channel can be made of the same semiconductor material with bandgap smaller than 0.9 eV. In embodiments of the present invention heterojunction materials may be used such that the effective bandgap is smaller than 0.9 eV, e.g. to ensure proper band to band tunneling between the source and the channel.

In embodiments of the present invention a dopant of the source 110 is a n-type dopant. In such embodiments the dopant of the drain may be n-type, intrinsic, or may even be p-type. The doping of the drain is sufficiently low so that the band (position in energy with regards to thew Fermi-level) is not fully degenerated/fixed by the doping.

In embodiments of the present invention a dopant of the source 110 is a p-type dopant. In such embodiments the dopant of the drain may be p-type, intrinsic, or may even be n-type. The doping of the drain is sufficiently low so that the band (position in energy with regards to thew Fermi-level) is not fully degenerated/fixed by the doping.

The operation principle of a FBFET in accordance with embodiments of the present invention is explained using an n-type transistor. The p-type operation can obviously be deduced from the n-type mechanism for someone skilled in the art.

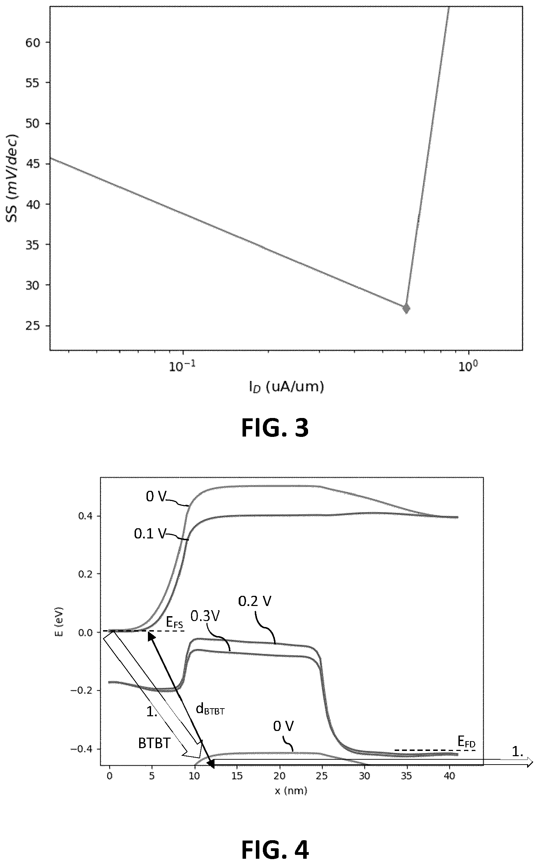

For explaining the operation principle an n-type CNT tunneling-enhanced FBFET in accordance with embodiments of the present invention is used. Such an FBFET is illustrated in FIG. 1. In this example the CNT has a diameter of 1.1 nm. For this example the drain 130 is doped with a donor concentration of 10¹⁹ cm⁻³. FIG. 2 shows the drain current ID versus gate voltage V_{G} characteristics in a forward sweep of a CNT tunneling enhanced FBFET, in accordance with embodiments of the present invention. The channel length for this example was 16 nm. A steep slope of 25 mV/decade is obtained. This is illustrated in FIG. 3 which shows the subthreshold slope in function of the drain current. In this example the drain voltage is 0.4 V.

When the device is switched to the off-state and the gate voltage V_{G} is such that due to band bending the valence channel energy barrier at the source side lies in proximity of the source conduction band, an electronic band-to-band-tunneling (BTBT) current is flowing from the source conduction band to the transistor valence band in the channel and to the drain. Proximity thereby means that the band is sufficiently close to enable a strong BTBT current, this can happen even before the bands are aligned in energy via high-energy (optical) phonon-assisted tunneling.
In a low bandgap material, especially if the drain band is lowly doped (typically lightly n-type doped, intrinsic or even lowly p-type) such that the band is not fully degenerated/fixed by the doping (the drain Fermi level lies in the bandgap), the polarity of the band can be inverted or made more strongly p-type due to the holes flowing in the drain due to the BTBT current if this current is strong enough. The Fermi level at the drain-side is then pinned towards the valence band due to the BTBT current and the structure behaves like a NIP device, although by doping the device may have been designed NIN. In other words, the valence band at the drain-side is moved toward higher energies (phase 1). This allows that any hole trapped in the channel valence band potential band barrier can escape to the drain-side (FIG. 4). As a consequence, an abrupt decrease of the positive charge (holes) in the channel triggers an abrupt increase of the channel energy barriers and an abrupt switching off the device. Due to this feedback mechanism, a small V_{G} change induce a very abrupt and steep slope switching.

FIGs. 2 to 10, illustrate a forward sweep in more details.

FIG. 2 shows the drain current versus gate voltage V_{G} characteristics in a forward sweep.

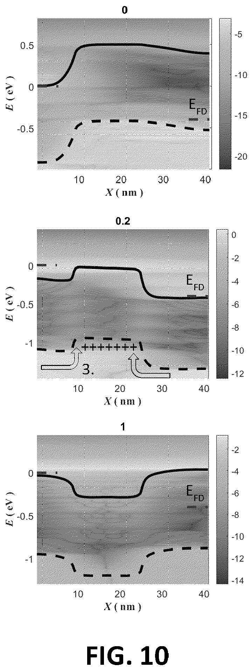

FIG. 4 shows the conduction band profile along the channel direction (x) for various gate voltages V_{G}. In a first phase of a forward sweep of a FBFET in accordance with embodiments of the present invention the gate voltage V_{G} is 0 V. For V_{G}=0 V, the top of the valence band is also visible. The BTBT distance at the source side between the valence band and the conduction band is indicated by d_{BTBT}. In the first phase (phase 1.) d_{BTBT} is sufficiently low such that the BTBT current and the transport charges it carries are high enough to invert the drain polarity. For V_{G}< 0.2 V (phase 1.), the drain Fermi level E_{FD} is pinned towards the valence band due to BTBT current flowing from the source side (see also the top graph of FIG. 10).

FIG. 10 shows the band profile and the current spectrum J(E) along the channel direction for V_{G}=0 V (top graph), for V_{G}=0.2 V (middle graph) and for V_{G}=1 V (bottom graph).

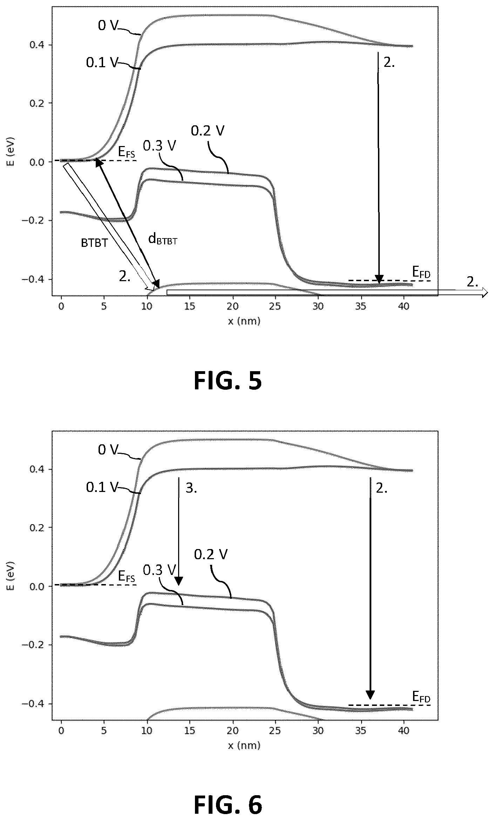

FIG. 5 shows the conduction band profile along the channel direction (x) for various gate voltages V_{G}. In FIG. 5 the second phase of the forward sweep of a tunneling FBFET in accordance with an exemplary embodiment of the present invention is further illustrated. As V_{G} is increased the BTBT tunneling distance d_{BTBT} is increasing and the BTBT current is reduced until the drain polarity reverts. For V_{G} approaching 0.2V (phase 2.) the energy bands at drain side are shifting down in energy. In particular, the conduction band shift towards the drain Fermi level E_{FD} (see also middle graph of FIG. 10). Phase 2 is a metastable/transient phase that will not last as it will immediately trigger phase 3. As the conduction band is shifting towards the drain Fermi level E_{FD}, this will allow for holes to fill the channel and trigger the feedback mechanism of phase 3.

FIG. 6 shows the conduction band profile along the channel direction (x) for various gate voltages V_{G}. In FIG. 6, as well as in the middle graph of FIG. 10 that shows both Ec and Ev profile at V_{G} = 0.2 V, the third phase of the forward sweep of a tunneling FBFET in accordance with an exemplary embodiment of the present invention is further illustrated. For V_{G} substantially equal to 0.2 V, immediately after the drain Fermi level E_{FD} has shifted towards the conduction band, the holes get trapped in the channel valence quantum well (phase 3.) and the channel barrier collapses. This is the feedback mechanism that enables a rapid drive current increase and the abrupt steep slope switching of the third phase (see FIG. 2 phase 3.).

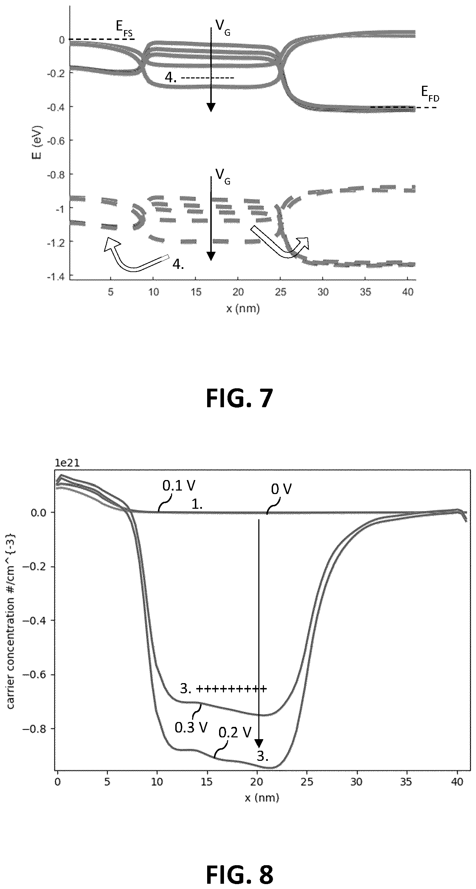

In FIG. 7 is illustrated that as V_{G} is further increased, the channel bands are pushed towards lower energy, and holes get de-trapped, while electron concentration is increased (see also bottom graph of FIG. 10) (phase 4.). This tends to counterbalance the electrostatic push of the gate potential so that after abrupt switch on, the current increases slowly, can even drop for increasing V_{G} and tends to saturate (see also FIG. 2 phase 4.).

FIG. 8 shows the carrier concentration (n-p) along the channel direction (x). For V_{G}<0.2 V (phase 1.) there are no trapped holes in the channel as the holes can escape from the channel via the drain. For V_{G} substantially equal to 0.2 V the holes get trapped (phase 3.) in the channel valence quantum well.

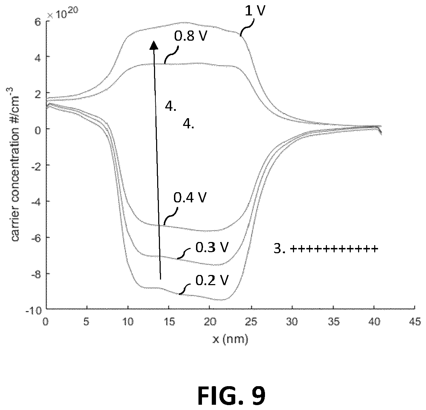

FIG. 9 shows the carrier concentration (n-p) along the channel direction (x). In the third phase the holes are trapped in the channel valence quantum well. In the fourth phase holes are de-trapped and electron concentration is increasing which is indicated with the upward arrow in FIG. 9.

In embodiments of the present invention extensions or metal contacts may be provided at the drain without compromising the operation of the device. Even with these extensions or metal contact it is still possible to reverse the polarity at the drain side. In embodiments of the present invention the device may for example comprise a source electrode in contact with the source region, and a drain electrode in contact with the drain region. It is an advantage of embodiments of the present invention that the polarity at the drain side can still be reversed when a source and drain contact is present. The polarity at the drain-side cannot be reverted and the steep SS is lost if both source and drain sides are highly doped (>5×10¹⁹ cm⁻³).

In embodiments of the present invention the length of the channel, and the length of the gate may for example be between 3 and 100 nm. The length of the source or drain may for example range between 3 and 40 nm.

Embodiments of the present invention also relate to a logic device. Such a logic device comprises a plurality of feedback field effect transistors according to any of the previous claims, wherein the feedback field effect transistors are arranged in a logic configuration. The logic device may for example be an inverter comprising two feedback field effect transistors of opposite polarity which are arranged such that an inverter is obtained. It is an advantage of embodiments of the present invention that it enables low-power logic with steep subthreshold slope operation (e.g. sub 60 mV/decade SS operation).

In a second aspect embodiments of the present invention relate to a method for operating a feedback field effect transistor. The method comprises applying a drain-source voltage between the drain region and the source region wherein the drain-source voltage is at least 0.2 V. The drain-source voltage may for example be between 0.2 and 0.55 V, for example between 0.35 and 0.4 V.

The method, furthermore, comprises increasing the gate voltage from 0 V to a first predefined gate voltage until the drain polarity reverts, and increasing the gate voltage from the first predefined voltage to a second predefined voltage to switch on the feedback field effect transistor.

It is an advantage of embodiments of the present invention that by applying a drain-source voltage between the drain region and the source region wherein the drain-source voltage is at least 0.2 V, a band to band tunneling occurs and results in an inversion of the drain polarity. By increasing the gate voltage to the first predefined voltage the band to band tunneling current decreases and results in a reverting drain polarity. At this point the charge carriers get trapped in the channel resulting in an abrupt barrier collapse. This feedback mechanism enables a rapid drive current increase and steep slope switching. The first predefined voltage for the gate may for example range between 0 and 0.3 V, and the second predefined voltage may for example between 0.2 and 0.5 V and is typically equal to the supply voltage V_{DD} that is also applied between the source and drain (V_{DS}) of the device in a digital circuit.

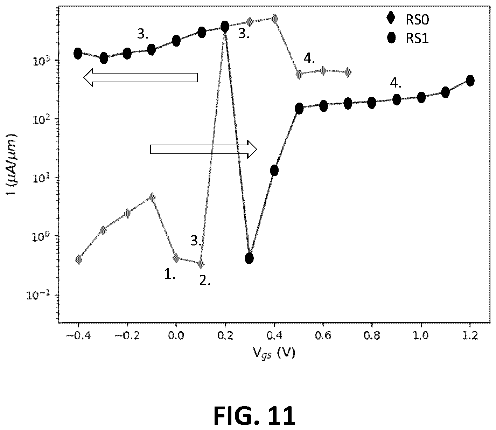

The graph shown in FIG. 2 illustrates the source drain current in function of the gate source voltage obtained by executing a method implementing a forward sweep in accordance with embodiments of the present invention. In embodiments of the present invention also a backward sweep may be applied. In a backward sweep the same method steps are applied in the reverse order, i.e. from a higher V_{gs} to a lower V_{gs} for a n-type device. This is for example illustrated in FIG. 11. The arrow pointing to the right indicates the direction of the V_{gs} sweep for a forward sweep RS0, and the left indicates the direction of the V_{gs} sweep for a backward sweep RS1. It can be seen that there is hysteresis between a backward sweep followed be a forward sweep and a forward sweep followed by a backward sweep resulting in a difference in conductivity at a reference gate voltage (e.g. V_{gs} = 0 V). This difference in conductivity can be used to obtain a memory device.

Embodiments of the present invention also relate to a memory device. Such a memory device comprises a FBFET in accordance with embodiments of the present invention. The memory device is configured for determining whether the FBFET is in a high or a low impedance state based on a conductivity of the FBFET.

This is possible because there is hysteresis between a forward and a backward sweep.

In embodiments of the present invention the feedback field effect transistor acts as a memory element and can be either in a low or high conductive state at a given reference gate voltage V_{gth} (e.g., V_{gs} = 0 V in Fig. 10) depending if the transistor underwent a full backward-forward cycle (low conductive state) or a forward-backward cycle (from V_{gth} to V_{gth}) owing to the hysteresis inherent to this device.

## Claims

1. A feedback field effect transistor (100), the feedback field effect transistor comprising a source region (110), a channel region (120), a drain region (130), and a gate (140), wherein the channel region (120) is between the source (110) and the drain region (130), wherein the source region (110), the channel region (120), and the drain region (130) are comprising a semiconductor material with a bandgap which is smaller than 0.9 eV and wherein the source region (110) and/or the drain region (130) have/has a dopant concentration which is smaller than 5×10¹⁹ cm⁻³ and wherein the gate is positioned along the channel and isolated from the channel.

2. A feedback field effect transistor (100) according to claim 1 wherein the semiconductor material is a carbon nanotube.

3. A feedback field effect transistor (100) according to claim 1 wherein the semiconductor material is selected from the list of germanium, III-V material, graphene, black phosphorus.

4. A feedback field effect transistor (100) according to any of the previous claims wherein the drain region (130) has a dopant concentration which is smaller than 5×10¹⁹ cm⁻³ and wherein the source region (110) has a dopant concentration of more than 5×10¹⁹ cm⁻³.

5. A feedback field effect transistor (100) according to any of the previous claims wherein a dopant of the source region (110) is a n-type dopant.

6. A feedback field effect transistor (100) according to any of the claims 1 to 4 wherein a dopant of the source region (110) is a p-type dopant.

7. A feedback field effect transistor (100) according to any of the claims 5 or 6 wherein a dopant of the drain region (130) has the same polarity as the dopant of the source region (110).

8. A feedback field effect transistor (100) according to any of the previous claims, the device comprising a source electrode in contact with the source region, and a drain electrode in contact with the drain region.

9. A feedback field effect transistor (100) according to any of the previous claims wherein a length of the channel is between 3 and 100 nm.

10. A feedback field effect transistor (100) according to any of the previous claims wherein a length of the source region or drain region is between 3 and 40 nm.

11. A logic device comprising a plurality of feedback field effect transistors according to any of the previous claims, wherein the feedback field effect transistors are arranged in a logic configuration.

12. A memory device comprising a feedback field effect transistor according to any of the previous claims wherein the memory device is configured for determining whether the feedback field effect transistor is in a high or low conductive state based on a conductivity of the feedback field effect transistor.

13. A method for operating a feedback field effect transistor according to any of the claims 1 to 9, the method comprising:
- applying a drain-source voltage between the drain region and the source region wherein the drain-source voltage is at least 0.2 V,
- increasing the gate voltage from 0 V to a first predefined gate voltage until a drain polarity reverts, and
- increasing the gate voltage from the first predefined voltage to a second predefined voltage to switch on the feedback field effect transistor.
